Europäisches Patentamt

European Patent Office

Office européen des brevets

(11) Publication number: **0 416 225 A2**

# EUROPEAN PATENT APPLICATION

(21) Application number: 90111632.7

(51) Int. Cl.5: **F02P 17/00, G01R 33/24**

(22) Date of filing: 20.06.90

(30) Priority: 08.09.89 US 404518

(43) Date of publication of application:
**13.03.91 Bulletin 91/11**

(84) Designated Contracting States:
**DE FR GB**

(71) Applicant: **SNAP-ON TOOLS CORPORATION**
**2801 - 80th Street**
**Kenosha, Wisconsin 53141(US)**

(72) Inventor: **Becker, Thomas P.**
**4727 - 70 Str.**
**Kenosha, Wisc. 53142(US)**
Inventor: **Rameshk, Sohrab S.**
**32196 North River Rd.**
**Libertyville, Ill. 60048(US)**
Inventor: **Crass, Matthew M.**
**1554 - 30 Ave.**
**Kenosha, Wisc. 53142(US)**

(74) Representative: **Wehnert, Werner, Dipl.-Ing. et al**
**Mozartstrasse 23**
**W-8000 München 2(DE)**

(54) Magnetic field pickup for automotive ignition diagnostics.

(57) A magnetic field pickup probe includes a circuit board base to which is secured a plastic bobbin with the axis of the bobbin perpendicular to the base. A helical coil is wound on the bobbin and has its end terminals connected to an output cable on the base. A metal core is disposed coaxially in the hollow hub of the bobbin and is integral at one end thereof with a circular metal shield which covers the bobbin end plate which is spaced from the base.

FIG. I

# MAGNETIC FIELD PICKUP FOR AUTOMOTIVE IGNITION DIAGNOSTICS

## Background of the Invention

### Field of the Invention

This invention relates to automotive engine ignition diagnostics, and specifically to pickup probe devices for detecting characteristic engine output signals for display and analysis on suitable diagnostic equipment. The invention has particular application to non-intrusive pickup probe devices which do not require physical connection to the engine being analyzed.

### Description of the Prior Art

Diagnostic systems for automotive engines are well known. Such systems typically have a display device, such as an oscilloscope, and a plurality of probe elements adapted to be coupled or connected to various components of the engine being analyzed for detecting a variety of engine output signals to analyze different engine operating conditions. Many of the conditions diagnosed by such systems relate to the ignition system of the automobile engine, and require access to the wires leading to the spark plugs, ignition coil, distributor and the like.

But recently new electronic engine ignitions have been used by automotive manufacturers. These systems include Distributorless Ignition Systems (DIS) wherein spark plugs are paired and fired simultaneously, and Direct Ignition (DI) wherein each spark plug has its own ignition coil. These systems facilitate complex computer control of engine function and do not require use of a distributor. Present oscilloscope diagnostics are not usable on these systems, at least in part because of inaccessibility of key portions of the ignition systems. For example, in such systems, the ignition coils are typically disposed beneath a shroud or cowl, so that there is no ready access to the primary and/or secondary wires of the ignition coils. Accordingly, current diagnostics systems which require direct connection or other coupling to the wires of the ignition coil cannot readily be used with the new types of ignition systems.

## Summary of the Invention

It is a general object of the present invention to provide an improved pickup probe for automotive ignition diagnostics which avoids the disadvantages of prior probes while affording additional structural and operating advantages.

An important feature of the invention is the provision of a pickup probe for automotive ignition diagnostics which is non-intrusive in that it does not require direct access to the ignition component being tested.

In connection with the foregoing feature, it is another feature of the invention to provide a magnetic field pickup probe which permits remote sensing of signals from an automotive ignition system.

Still another feature of the invention is a provision of a magnetic field sensor for use in a probe of the type set forth.

In connection with the foregoing feature, another feature of the invention is the provision of a magnetic field sensor of the type set forth, which is substantially unidirectional.

Yet another feature of the invention is the provision of a pickup probe and a magnetic field sensor therefor which are of simple and economical construction.

These and other features of the invention are attained by providing a magnetic field sensor comprising: a helical coil of electrically conductive wire having an axis extending between opposite ends of the coil, and a magnetizable metal shield covering only one end of the coil.

The invention consists of certain novel features and a combination of parts hereinafter fully described, illustrated in the accompanying drawings, and particularly pointed out in the appended claims, it being understood that various changes in the details may be made without departing from the spirit, or sacrificing any of the advantages of the present invention.

## Brief Description of the Drawings

For the purpose of facilitating an understanding of the invention, there is illustrated in the accompanying drawings a preferred embodiment thereof, from an inspection of which, when considered in connection with the following description, the invention, its construction and operation, and many of its advantages should be readily understood and appreciated.

FIG. 1 is a perspective view of a magnetic field pickup probe constructed in accordance with and embodying the features of the present invention;

FIG. 2 is a view in vertical section through a coreless magnetic field sensor, illustrating a source magnetic field and the magnetic field induced thereby in the sensing coil;

FIG. 3 is a view similar to FIG. 2, illustrating the effect of a core in the sensor;

FIG. 4 is a view similar to FIG. 3, illustrating the magnetic field sensor utilized in the probe of FIG. 1;

FIG. 5 is an enlarged, perspective view of the core structure of the sensor of FIG. 4;

FIG. 6 is an enlarged, perspective view of the bobbin of the sensor of FIG. 4;

FIG. 7 is a reduced, perspective view of the probe of FIG. 1, illustrating its manner of use with an engine including an electronic ignition system; and

FIG. 8 is a partially schematic and partially block circuit diagram of the probe of the present invention, illustrating its connection to a diagnostics oscilloscope and magnetic coupling to an ignition coil of the ignition system illustrated in FIG. 7.

### Description of the Preferred Embodiment

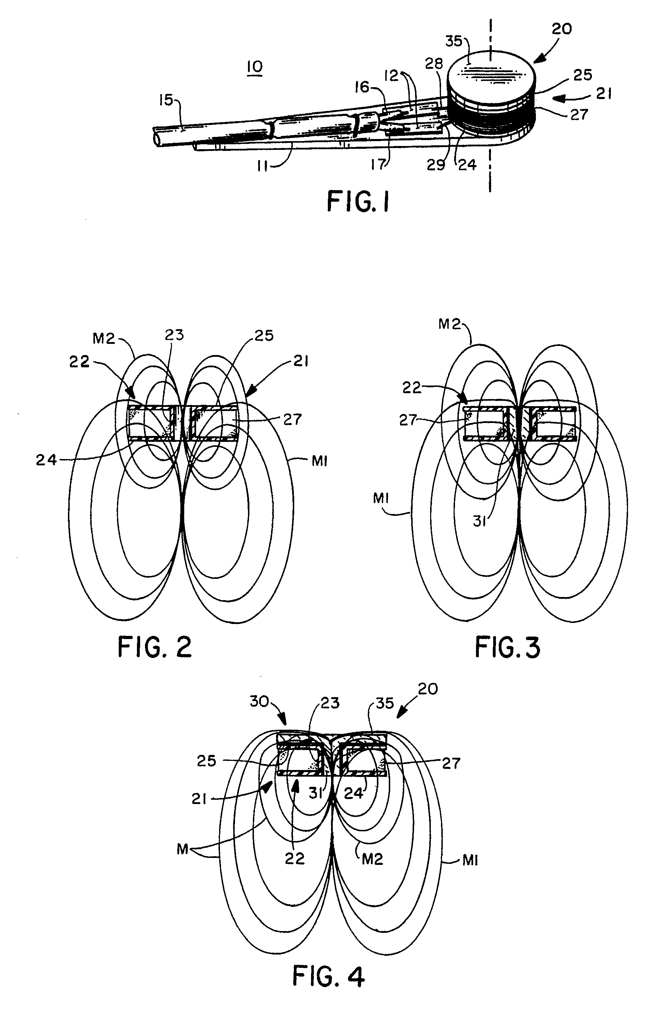

Referring to FIG. 1, there is illustrated a magnetic field pickup probe 10, constructed in accordance with and embodying the features of the present invention. The probe 10 includes a flat base 11, which may be in the form of an epoxy circuit board, on which are disposed a pair of solder strips 12. Coupled to the base 11 is one end of a shielded cable 15 having conductors 16 and 17 which are, respectively, connected to the solder strips 12. Secured to the base 11 at one end thereof is a magnetic field sensor 20.

Referring now also to FIGS. 4-6, the sensor 20 has an electromagnetic coil assembly 21, which includes a bobbin 22 formed of a non-magnetizable material, preferably a suitable plastic, such as nylon. The bobbin 22 includes a hollow, cylindrical hub 23, integral at the opposite ends thereof, respectively, with annular end plates 24 and 25 which extend radially outwardly from the hub 23 and are substantially parallel to each other. The coil assembly 21 further includes a helical coil of electrically conductive wire 27, which is wound on the hub 23 between the end plates 24 and 25 of the bobbin 22, the ends 28 and 29 of the coil 27 being respectively connected to the solder strips 12. The end plate 24 of the bobbin 22 is disposed in parallel engagement with the base 11 and may be fixedly secured there to by any suitable means such as by a suitable adhesive. Thus, the axis of the coil assembly 21 is substantially perpendicular to the base 11.

The sensor 20 also includes a core structure 30, which is generally T-shaped in transverse cross section (see FIG. 4) and is formed of a suitable magnetizable metal, such as steel. The core structure 30 includes a solid cylindrical core piece 31, which is disposed coaxially within the hub 23 of the bobbin 22, and a circular shield plate 35 which is integral with the core piece 31 at one end thereof and, in use, covers the end plate 25 of the bobbin 22 substantially congruent therewith. The core structure 30 may be secured to the bobbin 22 by any suitable means.

The function of the core structure 30 can be appreciated from an examination of FIGS. 2-4. FIG. 2 illustrates the magnetic field M2 induced in the coil assembly 21 by a magnetic field M1 from an external source, such as an automotive ignition coil. Referring to FIG. 3, the core piece 31 only of a core structure 30 has been added, and it can be seen that this serves to concentrate the induced magnetic field M2, thereby rendering the coil assembly 21 more sensitive to the source field M1. In both FIGS. 2 and 3, it can be seen that, although the source of the magnetic field M1 is located on one side of the coil assembly 21, it induces a magnetic field M2 which extends on both sides of the coil assembly 21, so that the coil assembly 21 is essentially bi-directional.

In FIG. 4, it can be seen that the addition of the shield plate 35 of the core structure 30 serves to block electromagnetic fields on the adjacent side of the sensor 20, thereby making the sensor 20 substantially unidirectional. This is significant in the testing of modern ignition systems having more than one ignition coil, since it will enhance the sensitivity of the sensor 20 to the coil under test and, minimize its sensitivity to adjacent coils.

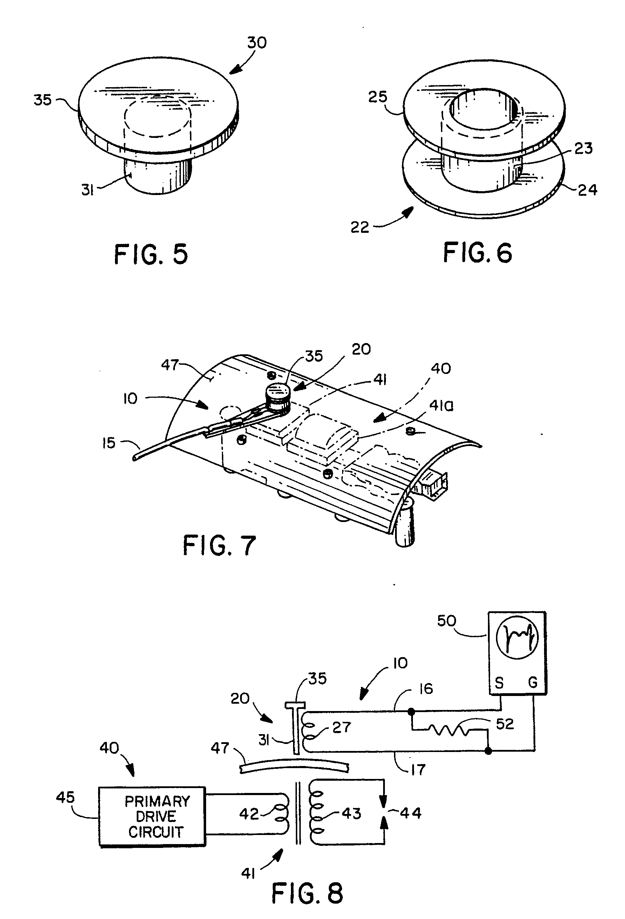

Referring now to FIGS 7 and 8, a typical application of the probe 10 is in testing of an engine ignition system 40 which includes multiple ignition coils, such as coils 41 and 41a. Each such coil includes a primary winding 42 and a secondary winding 43, the secondary winding 43 being connected to one or more associated spark plugs 44, and the primary winding 42 being connected to an associated primary drive circuit 45 (FIG. 8). Typically, the coils 41 and 41a are disposed in use beneath an associated non-magnetizable cowl or shroud 47, so that they are not readily accessible to service personnel.

By the use of the probe 10 of the present invention, electromagnetic signals from the coils 41 and 41a may be detected without direct access to the coil wires. In this case, the conductors 16 and 17 of the probe cable 15 are respectively connected to the signal and ground terminals of an associated oscilloscope 50, which may be a portion of an automotive diagnostic system. A suitable resistance 52 may be connected across the conductors 16 and 17 to lower the impedance thereof and provide noise reduction. The probe 10 is then disposed on the cowl 47 immediately above the coil 41 of 41a to be tested. More specifically, the probe 10 is disposed with the base 11 thereof facing the cowl and with the shield plate 35 disposed away from the cowl 47, as illustrated in FIG. 7. The magnetic field of the ignition coil being tested (typically the field generated by the primary winding of the ignition coil) will induce in the sensor 20 a magnetic field which will generate an output signal on the conductors 16 and 17 of the cable 15. This output signal is applied to the oscilloscope 50 to produce an indication of the signal waveform.

It has been found that with the use of the probe 10, the primary signal waveform from the coil of interest can be unambiguously detected and will have the same general shape as those of conventional ignition systems when detected by standard probes of prior art diagnostics systems. Thus, the basics of primary standard analysis will still apply and experienced engine technicians will require little or no specialized training in use of the probe 10.

In a constructional model of the probe 10, approximately three thousand turns of #42 AWG magnet wire were wound on the bobbin 22, providing approximately 800 ohms of DC resistance. The inductance of this coil was approximately 131 mH. The addition of the core structure 30 increased the inductance to approximately 241 mH.

From the foregoing, it can be seen that there has been provided an improved magnetic field pickup probe and a magnetic field sensor therefor, which are of simple and economical construction, providing unambiguous, yet remote and non-intrusive detection of electromagnetic signals generated by automotive ignition components.

## Claims

1. A magnetic field sensor comprising: helical coil of electrically conductive wire having an axis extending between opposite ends of the coil, and a magnetizable metal shield covering only one end of said coil.
2. The sensor of claim 1, and further comprising a bobbin of non-magnetizable material, said coil being wound on said bobbin.
3. The sensor of claim 2, wherein said bobbin includes a cylindrical hub and a pair of annular end plates extending radially outwardly from said hub at opposite ends thereof, said coil being wound around said hub between said end plates, said metal shield covering one of said end plates.
4. The sensor of claim 2, wherein said bobbin is formed of a plastic material.
5. The sensor of claim 1, wherein said metal shield is circular and coaxial with said coil.
6. A magnetic field sensor comprising: a cylindrical core of magnetizable metal having a cylindrical axis, a helical coil of electrically conductive wire wound coaxially about said core, and a magnetizable metal shield integral with said core at one end thereof and covering only the adjacent end of said coil.
7. The sensor of claim 6, and further comprising a bobbin of non-magnetizable material, said coil being wound on said bobbin.
8. The sensor of claim 7, wherein said bobbin includes a cylindrical hub and a pair of annular end plates extending radially outwardly from said hub at opposite ends thereof, said coil being wound around said hub between said end plates, said metal shield covering one of said end plates.
9. The sensor of claim 8, wherein said hub is hollow, said core being disposed within said hub coaxially therewith.
10. The sensor of claim 7, wherein said bobbin is formed of a plastic material.
11. The sensor of claim 6, wherein said shield is circular in shape and coaxial with said coil.
12. A magnetic field pickup probe for automotive ignition diagnostics comprising: a base; magnetic field sensor means carried by said base, said sensor means including a cylindrical core of magnetizable metal carried by said base and having a cylindrical axis, a helical coil of electrically conductive wire wound coaxially about said core, and a magnetizable metal shield integral with said core at one end thereof and covering only the adjacent end of said coil; and output means carried by said base and connected to said coil of wire, said sensor means being responsive to the presence of a magnetic field for producing an output signal at said output means.
13. The probe of claim 12, wherein said base includes an elongated handle portion to facilitate manipulation of said probe.
14. The probe of claim 12, wherein said output means includes an output cable adapted to be coupled to associated equipment.
15. The probe of claim 12, wherein said base is substantially planar, said cylindrical axis being disposed substantially perpendicular to said base.
16. The probe of claim 15, wherein said shield is spaced from said base.
17. The probe of claim 12, wherein said base includes an epoxy circuit board.
18. The probe of claim 12, wherein said sensor means further includes a bobbin formed of non-magnetizable material, said coil being wound on said bobbin.

19. The probe of claim 18, wherein said bobbin includes a hollow cylindrical hub and a pair of annular end plates extending radially outwardly from said hub respectively at the opposite ends thereof, said core being disposed within said hub coaxially therewith, said coil being wound around said hub between said end plates, said shield covering one of said end plates.

FIG. I

FIG. 2

FIG. 3

FIG. 4

**FIG. 5**

**FIG. 6**

**FIG. 7**

PRIMARY
DRIVE
CIRCUIT

**FIG. 8**

7